# EUROPEAN PATENT APPLICATION

(11) **EP 4 242 854 A1**
(43) Date of publication of application: **13.09.2023**
(21) Application number: 23158557.1
(22) Date of filing: 24.02.2023
(51) Int. Cl.: G06F 11/36, G06F 30/20

(54) **SYSTEM AND METHOD FOR PROVIDING AUTONOMOUS DRIVING SIMULATION ARCHITECTURE WITH SWITCHABLE MODELS**

(30) Priority: 07.03.2022 US 202217687888
(71) Applicant: Woven by Toyota, Inc., Tokyo 103-0022 (JP)
(72) Inventor: SUN, Linyu, Tokyo, 103-0022 (JP)
(74) Representative: J A Kemp LLP

(57) **Abstract**

A device and a method for providing an autonomous driving simulation architecture for testing an application. The method includes integrating a plurality of simulation data models with a first core simulator that runs an autonomous vehicle simulation for testing the application; selectively connecting the first core simulator to the application; and selectively disconnecting a first simulation data model, among the plurality of simulation data models, from the first core simulator.

## Description

### BACKGROUND

### 1. Technical Field

The disclosure relates to the field of autonomous driving simulation technology, and in particular, to a system and a method of integrating autonomous driving simulation models and tools.

### 2. Description of Related Art

As the development of autonomous vehicles evolves at an accelerated pace, so too has the development of autonomous vehicle software applications that control (or affect control of) the vehicles. A software or application developer for an autonomous vehicle (ego vehicle) must be able to test and verify the safety and proper functioning of an application before its release. This is done using an autonomous driving simulation system that simulates an ego vehicle's operations. A related art autonomous driving simulation system includes a core simulator, a vehicle simulator, and one or more sensor simulators.

The core simulator is the simulation tool that creates, edits, and/or executes a scenario in which a simulation is run. Via the core simulator, the virtual world of the simulation can be defined, as well as the actors and their movements. The vehicle simulator simulates an autonomous driving vehicle (ego vehicle) and includes a vehicle controller to control a position of the vehicle based on surrounding objects. The sensor simulator simulates various sensors of the ego vehicle, such as a camera sensor model for capturing images of the ego vehicle's surroundings in the virtual world.

At the core of testing an application under development, software developers often test the application using a combination of simulation data models. These simulation models, however, may originate from various sources with different formats for input and output of data. Thus, a software developer is limited by the core simulator as to which simulation data models can be used for testing. There is therefore a need for a common architecture that can integrate the variably-sourced models and tools into a single simulation environment in order to streamline testing, expand the library or selection of simulation models to choose from, and shorten the software development cycle without compromising safety.

Further, depending on the application under development, some data models may be essential for testing while others may not. For example, one application (e.g., autonomous driving stack) may require both a vehicle simulation model and a sensor simulation model integrated or implemented with a core simulator for testing, whereas another application (e.g., perception application) may require only a sensor simulation model to be integrated or implemented with the core simulator for testing.

Accordingly, a common simulation architecture in which different models are integrated to process simulation data in different formats is needed, in order to accommodate the variable testing requirements of different types of applications. Such an architecture, however, may include models that are not required or essential for testing a given application, thereby incurring unnecessary costs for developers, imposing excessive burden on the processing load, and consuming more time for testing. For example, a certain application may not require highly accurate image or sensor data for testing. In such a case, a common simulation architecture that implements or includes a highly accurate sensor simulator would result in unnecessary cost to the developer, burden on the processing load, and excess time for testing.

### SUMMARY

The present disclosure provides an autonomous driving simulation architecture capable of integrating different simulation data models from different sources (e.g., simulator suppliers, vendors, etc.) and allowing for any particular model to be switched on or off and/or exchanged with a "dummy" model according to the functionality or testing requirements of an application. Accordingly, a customized simulator satisfying the minimum viable requirements for testing a given application is attainable to thereby reduce cost, complexity, processing time, and processing load.

An aspect of the present disclosure provides a server for providing an autonomous driving simulation architecture for testing an application. The server includes a storage storing a plurality of simulation data models, and at least one processor. The at least one processor is configured to execute instructions to implement: at least one first interface to integrate the plurality of simulation data models with a first core simulator that runs an autonomous driving simulation for testing the application; a common interface to selectively connect the first core simulator to a client device providing the application; and a first switch to selectively disconnect a first simulation data model, among the plurality of simulation data models, from the first core simulator.

In the above aspect, the first switch may disconnect the first simulation dummy model by switching from the first simulation data model to a first dummy model, for integration with the first core simulator via the at least one first interface; and the first dummy model may be of lower accuracy than the first simulation data model.

In the above aspect, the at least one processor may be further configured to execute the instructions to implement at least one second interface to connect one or more of the plurality of simulation data models with a second core simulator.

In the above aspect, the common interface may selectively connect the first core simulator or the second core simulator to the client device.

In the above aspect, the at least one processor may be further configured to execute the instructions to implement a second switch to selectively switch between a second simulation data model, among the plurality of simulation data models, and a second dummy model, for integration with the first core simulator.

In the above aspect, the plurality of simulation data models may include a vehicle simulation model for simulating an ego vehicle, and a sensor simulation model for simulating one or more sensors of the ego vehicle.

In the above aspect, the at least one first interface may be configured to convert data between one or more data formats of the plurality of simulation data models and a data format of the first core simulator.

Another aspect of the present disclosure provides a method for providing an autonomous driving simulation architecture for testing an application. The method includes: integrating a plurality of simulation data models with a first core simulator that runs an autonomous vehicle simulation for testing the application; selectively connecting the first core simulator to the application; and selectively disconnecting a first simulation data model, among the plurality of simulation data models, from the first core simulator.

In the above aspect, the selectively disconnecting the first simulation data model from the first core simulator may include: controlling a first switch to disconnect a first simulation dummy model by switching from the first simulation data model to a first dummy model, for integration with the first core simulator, wherein the first dummy model is of lower accuracy than the first simulation data model.

In the above aspect, the method may include connecting one or more of the plurality of simulation data models with a second core simulator.

In the above aspect, the method may include selectively connecting the first core simulator or the second core simulator to a client device via a common interface.

In the above aspect, the method may include controlling a second switch to selectively switch between a second simulation data model, among the plurality of simulation data models, and a second dummy model, for integration with the first core simulator.

In the above aspect, the plurality of simulation data models includes a vehicle simulation model for simulating an ego vehicle, and a sensor simulation model for simulating one or more sensors of the ego vehicle.

In the above aspect, the method may include converting data between one or more data formats of the plurality of simulation data models and a data format of the first core simulator.

Another aspect of the present disclosure provides a non-transitory computer-readable storage medium storing instructions executable by at least one processor to perform a method. The method includes: integrating a plurality of simulation data models with a first core simulator that runs an autonomous vehicle simulation for testing the application; selectively connecting the first core simulator to the application; and selectively disconnecting a first simulation data model, among the plurality of simulation data models, from the first core simulator.

### BRIEF DESCRIPTION OF THE DRAWINGS

Features, advantages, and technical and industrial significance of exemplary embodiments of the disclosure will be described below with reference to the accompanying drawings, in which like signs denote like elements, and wherein:
FIG. 1 is a diagram illustrating a system for implementing an autonomous driving simulation architecture according to an embodiment;
FIG. 2 is a detailed block diagram illustrating a system for implementing an autonomous driving simulation architecture according to an embodiment;
FIG. 3 is a flowchart illustrating a method of providing an autonomous driving simulation architecture according to an embodiment; and
FIG. 4 is a block diagram illustrating an autonomous driving simulation architecture according to an embodiment.

### DETAILED DESCRIPTION

Embodiments of the disclosure are described in detail below with reference to the accompanying drawings. The same reference numerals used in the drawings may identify the same or similar elements. The terms used in the disclosure should not be strictly construed as defined in the disclosure, but should be construed as those one of ordinary skilled in the art would understand in the context of the disclosure. Further, it should be noted that the embodiments of the disclosure may be in different forms and are not limited to the embodiments set forth herein.

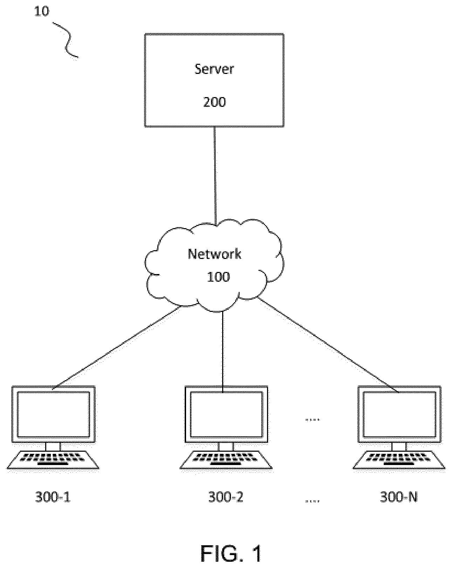

FIG. 1 is a diagram illustrating a system 10 implementing an autonomous driving simulation architecture according to an embodiment.

Referring to FIG. 1, a system 10 for implementing an autonomous driving simulation architecture may include a network 100, a server 200 and a plurality of terminal devices 300-1 to 300-N (collectively, "terminal devices 300"). The terminal devices 300 (or client devices) may be connected to the server 200 through the network 100. The terminal devices 300 may be any computing device, including without limitation at least one of a server, a desktop computer, a laptop, a work station, a mobile computing device, etc. The server 200 may be implemented as an independent server or as a server cluster including a plurality of servers. The server 200 may include an autonomous driving simulation architecture according to an embodiment, from which customized simulators can be respectively provided to each of the terminal devices 300 that provide applications for testing. For example, each of the terminal devices 300 may correspond to a different application developer.

The network 100 may include wired and/or wireless communication networks, and may include any number of networks. The network 100 may exchange data in circuit-switched and/or packet-switched channels. For example, the networks may include telecommunication networks, local area networks, wide area networks, WiFi networks, and/or the Internet.

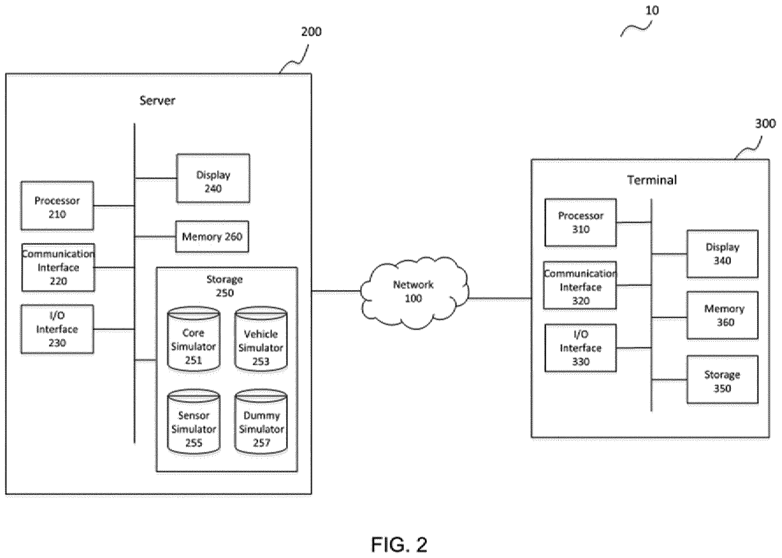

FIG. 2 is a detailed diagram illustrating a system 10 implementing an autonomous driving simulation architecture according to an embodiment.

Referring to FIG. 2, the server 200 may include a processor 210, a communication interface 220, an input/output interface 230, a display 240, a storage 250, and a memory 260. The terminal devices 300 may each include a processor 310, a communication interface 320, an input/output interface 330, a display 340, a storage 350 and a memory 360. As set forth above, the server 200 may be provided as a plurality of servers, each storing or executing different assets, models, simulators, etc. Here, the components of the server 200 and the terminal devices 300 may be configured to perform the same or similar functions. Therefore, for the convenience of description, the components of the server 200 will be mainly described herein.

The processor 210 may control an overall operation of the server 200. Specifically, the processor 210 may be connected to and configured to control the operations of the memory 260, the communication interface 220, the input/output interface 230, and the display 240. For example, the processor 210 may be implemented as at least one of an application specific integrated circuit (ASIC), an embedded processor, a microprocessor, hardware control logic, a hardware finite state machine (FSM), a digital signal processor (DSP), a neural network processor (NPU), or the like. The processor 210 may include a central processing unit (CPU), a graphic processing unit (GPU), and a main processing unit (MPU), or the like. In addition, the processor 210 may include one or more processors.

The memory 260 may store at least one instruction and various software programs or applications for operating the server 200 according to embodiments of the disclosure. For example, the memory 260 may include a semiconductor memory, such as a flash memory, a magnetic storage medium such as a hard disk, or the like. The memory 260 may refer to any volatile or non-volatile memory, a read-only memory (ROM), a random access memory (RAM) communicatively coupled to the processor 210 or a memory card (e.g., a micro SD card, a memory stick) connectable to the server 200.

Specifically, the memory 260 may store various software modules or codes for operating the server 110, and the processor 210 may control the operations of the server 200 by executing various software modules that are stored in the memory 260. That is, the memory 260 may be accessed by the processor 210 to perform data reading, recording, modifying, deleting, updating or the like.

The memory 260 may store an autonomous driving operating system (OS) for autonomous control of a vehicle, such as an operating system executable on an electronic control unit (ECU) of a vehicle. The memory 260 may also store at least one application programming interface (API) to interface the OS with applications used for autonomous driving, including those applications that may be tested via the simulation architecture disclosed herein. The at least one API may communicate with applications using a common messaging format (e.g., ROS, ROS2, etc.). Further, the memory 260 may store middleware for communication between the autonomous driving OS and simulation models, such as a core simulator 251, a vehicle simulation model 253, a sensor simulation model 255, dummy simulation models 257, etc. The middleware may include one or more data translators to translate between the messaging format(s) of the simulation models (e.g., DIRECT ACCESS, GRPC, etc.), as well as to translate to/from the data format of the OS (e.g., the common messaging format of the OS).

The communication interface 220 may include circuitry that is configured to communicate with the terminal devices 300 through the network 100. The communication interface 220 may include at least one of a Wi-Fi module, a Bluetooth module, a wireless communication module, or a near field communication (NFC) module. Specifically, the Wi-Fi module may communicate by a Wi-Fi method and the Bluetooth module may communicate by a Bluetooth method. When using the Wi-Fi module or the Bluetooth module, various connection information such as service set identifier (SSID) may be transmitted and received for communication connection and then various information may be transmitted and received.

The input/output interface 230 may be configured to receive an input from a user or other devices, and the processor 210 may receive a user command for controlling the operation of the server 200 through the input/output interface 230. The input/output interface 230 may include, for example, a microphone, a camera, a remote controller, a keyboard, a mouse, or the like.

The display 240 may be implemented as a liquid crystal display (LCD) panel, organic light emitting diodes (OLED), a flexible display, a touch screen display, a transparent display, or the like. The processor 210 may control the display 240 to display image signals received from the memory 260 or received from the terminal device 300 through the communication interface 220. However, the implementation of the display 240 is not limited thereto.

The storage 250 may be configured to store various simulation models for providing an autonomous driving simulation architecture. For example, the storage 250 may store executable instructions, code, data objects, etc., corresponding to one or more core simulators 251, one or more vehicle simulators 253 (or vehicle simulation models), one or more sensor simulators 255 (or sensor simulation models), and one or more dummy simulators 257 (or dummy simulation models). Here, the storage 250 may be provided in the form of a non-transitory storage medium that is a tangible device that may not include a signal (e.g., electromagnetic wave). As described above, it is understood that the above-described simulators and models may be distributed across a plurality of servers.

The core simulator 251 may be a primary simulation tool that creates, edits and executes scenarios in which a simulation of an autonomous vehicle may be performed. For example, the core simulator 251 may define a virtual world or environment as well as the actors and the actors' movements in the virtual environment. Specifically, the core simulator 251 may be configured to simulate a scenario that includes a pedestrian and a non-ego vehicle that is moving at a particular speed over a particular trajectory to test how the ego vehicle will behave or operate in such a scenario. Here, the term ego vehicle may refer to a vehicle that is controlled by an automated driving system (ADS) or at least equipped with the ADS. The ADS may provide self-driving capabilities in which no physical action is required by an ego driver who may manually control the vehicle. The self-driving capabilities may include, for example, navigating or driving the vehicle using various sensors and software without human intervention.

The vehicle simulator 253 may be a model that simulates the ego vehicle. The vehicle simulator may include a vehicle dynamics simulation that simulates the vehicle's physical motions, a vehicle controller or unit simulation that simulates various units of the vehicle (e.g., engine, battery, air conditioner, etc.), and a vehicle body simulation that simulates components of the vehicle body (e.g., lights, doors, warning lamps, etc.). The vehicle simulator 253 may be supplied by a car manufacturer and/or may correspond to a particular vehicle and the attributes thereof.

The sensor simulator 255 may be a model that simulates various sensors of the ego vehicle. The sensors that may be simulated by the sensor simulator 255 may include a camera, a LiDAR sensor, a radar sensor, etc. For example, the sensor simulator 255 may output camera images of the simulated scenes. The sensors that may be simulated by the sensor simulator 255 are not limited thereto, and may include other sensors that may be relevant to providing self-driving capabilities of the ego vehicle.

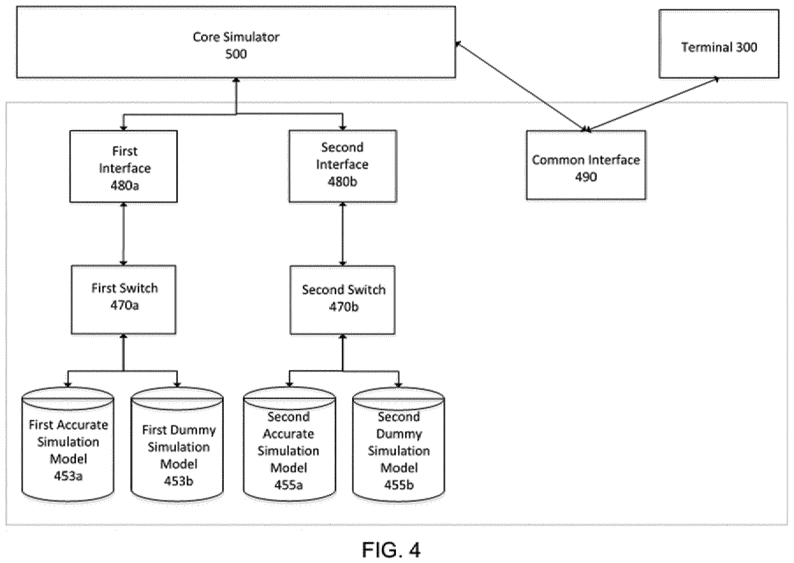

Furthermore, the storage 250 may also store one or more dummy simulators 257 that may replace other simulation models or may be integrated or implemented with the one or more core simulators 251. The dummy simulator 257 is described in more detail below with reference to FIG. 4.

According to an embodiment, the core simulator 251, the vehicle simulator 253, the sensor simulator 255 and the dummy simulator 257 may be stored in the memory 260, or may be temporarily stored in the memory 260 to be processed by the processor 210.

As noted above, the components of the terminal device 300 (e.g., a processor 310, a communication interface 320, an input/output interface 330, a display 340, a storage 350 and a memory 360) may be configured the same as or similar to the components described above with respect to the server 200. It is understood, however, that the components of the terminal devices 300 may be configured differently from that of the server 200. For example, the terminal devices 300 may not store the core simulator 251, the vehicle simulator 253, the sensor simulator 255 and the dummy simulator 257, and may not sore the autonomous driving OS. Rather, each terminal device 300 may execute an application under development or testing with use of the autonomous driving simulation architecture. To this end, the terminal device 300 may transmit and receive messages and data to and from the server 200 that provides the autonomous driving simulation architecture.

In addition, according to an embodiment, a method and a device disclosed herein may be provided as software of a computer program product. A computer program product may be distributed in the form of a machine readable storage medium (e.g., compact disc read only memory (CD-ROM)) or distributed online through an application store or between two devices directly. In the case of on-line distribution, at least a portion of the computer program product (e.g., a downloadable app) may be stored temporarily or at least temporarily in a storage medium such as a manufacturer's server, a server in an application store, or a memory in a relay server.

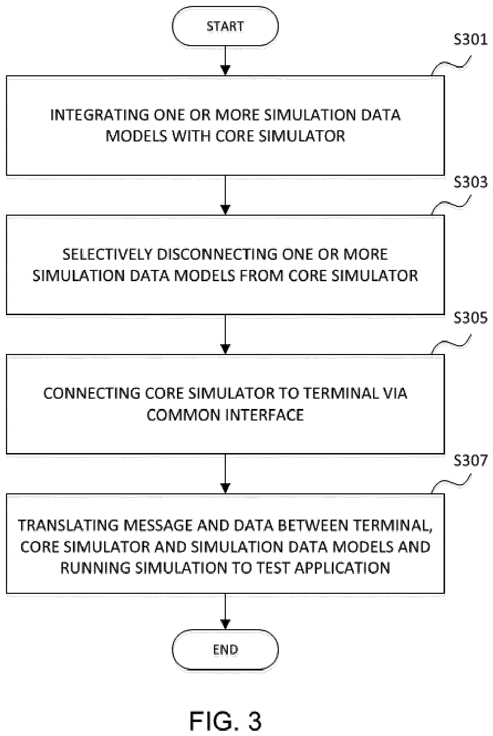

FIG. 3 is a flowchart illustrating a method of providing an autonomous driving simulation architecture according to an embodiment.

According to an embodiment, the method of providing an autonomous driving simulation architecture can be performed or controlled, via executing instructions, by the processor 210 of the server 200 (shown in FIG. 2).

Referring to FIG. 3, in step S301, a common autonomous driving simulation architecture according to an embodiment is provided. For example, the common autonomous driving simulation architecture is provided by integrating one or more of a plurality of simulation data models with one or more core simulators. The plurality of simulation data models may be provided in the server 200, and the core simulator may be provided in the same server 200 or a distinct server. The one or more simulation data models may be connected to the core simulator via an interface (simulation data model interface) in the server 200 that translates the data between an output format(s) of the one or more simulation data models and the input format of the core simulator. The simulation data model interface may be one or more interfaces realized by instructions executed by the processor 210. Further, the simulation data model interface may be included in simulator middleware of the server 200.

The autonomous driving simulation architecture according to an embodiment may include a plurality of core simulators, e.g., a first core simulator configured or optimized for software-in-the-loop simulation and a second core simulator configured or optimized for hardware-in-the-loop simulation. The plurality of core simulators may originate from different sources or different vendors. The simulation data models may be used (or reused) by the different core simulators via selective connections between the simulation data models and the core simulators (e.g., by use of logical switches responsive to user input, input instructions, etc.), and via selective connections between the respective core simulators and the application under development. The selective connections may be controlled (ON/OFF) by input of a user.

By way of example, the one or more simulation data models may include a vehicle simulation model that inputs and outputs data in a first format or protocol (e.g., DIRECT ACCESS), a sensor emulator or simulation model that inputs and outputs data in the first format or a second format, three-dimensional assets (e.g., mesh, material, texture, animation, etc.) usable in various simulation scenarios, etc. The simulation data model interface is configured to translate the data of the first format and/or second format into a third message format (e.g., GRPC) of the core simulator, and vice-versa.

By use of simulation data model interfaces that include data translators, simulation data models from any of plural different sources may be integrated with a plurality of different core simulators. Thus, embodiments of the disclosure provide an improved autonomous driving simulation architecture that expands the number and variety of available simulation models for use in testing an application for an ego vehicle.

In step S303, one or more switches are controlled to selectively disconnect at least one of the one or more simulation data models from the core simulator. For example, the server 200 may receive a direct user input or an input from a terminal 300 (e.g., a terminal of an application developer) as to at least one simulation data model (or accurate model) that is not required, essential, or desired for a given simulation or for testing a particular application.

According to an embodiment, the processor 210 of the server 200 may be configured to receive, through the communication interface 220, an input command from the terminal device 300 and input by a user. Here, the input command may be received from the user by the input/output interface 330 of the terminal device 300, and the received input command may be transmitted to the server 200 through the communication interface 320 of the terminal device 300. However, one or more other embodiments are not limited thereto, and the input command may be directly received by the input/output interface 230 of the server 200.

As described above, one application (e.g., autonomous driving stack) may require both a vehicle simulation model and a sensor simulation model integrated or implemented with the core simulator for testing, whereas another application (e.g., perception application) may require only a sensor simulation model to be integrated or implemented with the core simulator for testing. In the latter case, the vehicle simulation data model (or an accurate vehicle simulation data model) may be switched off or disconnected from the core simulator. Here, a switch (e.g., instructions executable by the processor 210) may disconnect the vehicle simulation data model by switching from the vehicle simulation data model to a dummy model for integration with the core simulator via the interface (i.e., simulation data model interface). The dummy model is of lower accuracy and/or complexity than the disconnected data model (e.g., the vehicle simulation data model). Therefore, a user can reduce a processing load by disconnecting the vehicle simulation model that is not required or needed for testing the application from the core simulator, while only integrating the sensor simulation model that is required or needed for testing the application. According to an embodiment, the processor 210 may be configured to obtain the dummy model from the storage 250 and integrate the obtained dummy model to the core simulator via the interface.

In step S305, the core simulator is connected to a terminal 300, such as a client device or system of an application developer. The core simulator is connected to the terminal 300 via an interface (common interface) in the server 200. The common interface is configured to connect the core simulator to the terminal 300 via at least one of middleware, an application programming interface, a common operating system, or a common ecosystem that interfaces the simulation architecture provided by the server 200 with an application under development or testing in the terminal 300. The common interface is implemented by instructions executed by the processor 210 to translate or convert the data of a messaging format of the core simulator (e.g., GRPC) into a common message format (e.g., ROS, ROS2, etc.) of the common operating system or ecosystem through which an application on the terminal 300 is simulated, and vice-versa.

In step S307, the simulation is run and the application is tested by translating messages and data between the terminal 300, the core simulator, and the connected simulation models using the simulation data model interface(s) and the common interface. The simulation data model interface(s) and/or the common interface may be included in an application programming interface, middleware, etc., executed in the server 200.

When the core simulator is run to test an application, log data may be generated according to the performance of the application, and this log data may be subsequently used or replayed by a log player to debug the application. For example, in the case of the autonomous driving stack, an application may input image data from two cameras being simulated by a sensor simulation or emulator model, to the core simulator, and the core simulator may output vehicle control data to a vehicle simulation model based on the input image data from the two cameras. In this way, the core simulator can test or simulate the application in which a scenario can be visualized or studied by the developer with respect to the input image data from the two cameras and output vehicle control data that controls the ego vehicle based on the input image data. Based on such visual observation, the developer may, for example, decide not to input image data from one of the two cameras and rerun the simulation to test if more accurate vehicle control data for the ego vehicle can be generated based on the image data from only one camera.

As described above, the server 200 includes one or more simulation data model interfaces that translate data between an output format(s) of one or more simulation data models and the input format of the core simulator. Further, the server 200 includes a common interface to connect the core simulator to a terminal by translating messages between data or messaging formats of the core simulator and a common format of the architecture or ecosystem provided by the server 200. The server 200 may further include an additional interface to convert data or messages between the common format and a data or messaging format of the terminal 300. Accordingly, embodiments provide a common simulation architecture that is able to integrate different models from different sources that process data in different formats.

Further, the server 200 includes one or more switches to selectively disconnect one or more of the simulation models. Accordingly, embodiments provide the common simulation architecture that is able to accommodate the variable testing requirements of different types of applications, and provide a customized simulation tool that meets the minimum viable requirements of the application under test. As a result, cost, processing load, and a time for testing a given application are reduced.

FIG. 4 is a block diagram illustrating an autonomous driving simulation architecture according to an embodiment.

As described above, under a certain application testing environment, a dummy model may be provided in lieu of a more accurate simulation data model in order to reduce the processing load and to reduce the cost associated with implementing the autonomous driving simulation.

Referring to FIG. 4, the autonomous driving simulation architecture according to an embodiment includes a core simulator 500, a first accurate simulation model 453a, a first dummy simulation model 453b, a second accurate simulation model 455a, a second dummy simulation model 455b, a first switch 470a, a second switch 470b, a first interface 480a, a second interface 480b, and a common interface 490. It is understood that one, some, or all of the above-described components may be implemented by instructions executed by at least one processor 210 of the server 200, or may be implemented by instructions executed by processors distributed across multiple servers. As one example, the core simulator 500 and/or the first accurate simulation model 453a may be provided in one or more distinct servers.

The core simulator 500 is the simulation tool that creates, edits, and/or executes a scenario in which the simulation is run. Via the core simulator 500, the virtual world of the simulation can be defined, as well as the actors and their movements. The core simulator 500 may create or edit a scenario using three-dimensional assets stored in the same server as the core simulator, or in a distinct server. Further, the core simulator 500 may include a renderer to render the three-dimensional assets. The three-dimensional assets may include mesh, material, texture, and animation objects. The core simulator 500 executes the scenario in which the simulation is run. While the architecture illustrated in FIG. 4 includes one core simulator 500, it is understood that embodiments are not limited thereto, and a plurality of core simulators may be provided. For example, a first core simulator may be a software-in-the-loop simulator, and a second core simulator may be a hardware-in-the-loop simulator. Additional switches and/or translators may be provided to selectively connect/disconnect a core simulator for a given simulation to a terminal 300 and to the simulation data models.

The first interface 480a (or first simulation data model interface) includes a translator to convert a first message (or data) format of the first simulation model 453a to a third message (or data) format of the core simulator 500. The second interface 480b (or second simulation data model interface) includes a translator to convert a second message (or data) format of the second simulation model 455a to the third message (or data) format of the core simulator 500. Here, the first message format and the second message format may be the same or different. If the two message formats are the same, then the first and second interfaces 480a and 480b may be replaced by a single interface. As set forth above, the first and second interfaces 480a and 480b may be implemented as instructions executable by the processor, and may be included in middleware, an application programming interface, or a component of an operating system of the server 200.

The first accurate simulation model 453a and the second accurate simulation model 455a are simulation data models for emulating various components of an autonomous vehicle. For example, the first accurate simulation model 453a may be a vehicle simulation model that simulates the autonomous or ego vehicle. The vehicle simulation model may include a vehicle dynamics simulation that simulates the vehicle's physical motions, a vehicle controller or unit simulation that simulates various units of the vehicle (e.g., engine, battery, air conditioner, etc.), and a vehicle body simulation that simulates components of the vehicle body (e.g., lights, doors, warning lamps, etc.). Further, the second accurate simulation model 455a may be sensor simulation model that simulates various sensors of the ego vehicle, such as a camera, a LiDAR sensor, a radar sensor, etc.

Although the embodiment of FIG. 4 is illustrated as including only two accurate simulation models, it is understood that the autonomous driving simulation architecture according to one or more other embodiments is not limited thereto, and may include more than two accurate simulation models.

The first dummy simulation model 453b and the second dummy simulation model 455b respectively correspond to the first accurate simulation model 453a and the second accurate simulation model 455a, but with lower accuracy, complexity, cost, processing time, and/or processing demand. Although the embodiment of FIG. 4 is illustrated as including only two dummy simulation models, it is understood that the autonomous driving simulation architecture according to one or more other embodiments are not limited thereto, and may include more than or less than two dummy simulation models. Further, it is understood that there may be included more than one dummy simulation model in correspondence with an accurate simulation model. For example, two or more dummy simulation models of varying degrees of complexity and/or accuracy may be included in correspondence with one accurate simulation model. In this case, a corresponding switch may be configured to selectively switch to one of the plural dummy simulation models.

The first switch 470a selectively switches between the first accurate simulation model 453a and the first dummy simulation model 453b for connection to the core simulator 500 via the first interface 480a. Similarly, the second switch 470b selectively switches between the second accurate simulation model 455a and the second dummy simulation model 455b for connection to the core simulator 500 via the second interface 480b. Although the embodiment of FIG. 4 is illustrated as including only two switches, it is understood that the autonomous driving simulation architecture according to one or more other embodiments are not limited thereto, and may include more than or less than two switches depending, for example, on the number of dummy simulation models included in the architecture.

The common interface 490 includes a translator to translate messages between the core simulator 500 and the terminal 300. In particular, the translator converts a messaging format of messages and data output by the core simulator 500 from the third message format (e.g., GRPC) of the core simulator 500 to a fourth message format that may be a common message format of the operating system or ecosystem of the autonomous driving simulation architecture 400. By way of example, the fourth message format may be ROS, ROS2, etc. Further, the translator converts a messaging format of messages and data input to the core simulator 500 (e.g., from the terminal 300) from the fourth message format to the third message format of the core simulator 500. According to an embodiment, the common interface 490 may also include one or more switches to selectively connect and/or disconnect one or more core simulators from the terminal 300.

Based on an input command (e.g., from a user or manager of the simulation architecture), instruction, or specific implementation design, one or more switches described above may be controlled to provide a simulation tool or package from the common simulation architecture that is customized for a particular customer (e.g., application developer) or for a particular application to be tested. For example, in one implementation, the simulation tool may be customized by operating the first switch 470a to disconnect the first accurate simulation model 453a and connect the first dummy simulation model 453b.

In further detail, an application such as an autonomous driving stack may require both a vehicle simulation model and a sensor simulation model integrated or implemented with the core simulator for testing, whereas another application such as perception application may require only a sensor simulation model to be integrated or implemented with the core simulator for testing. In the latter case, the first switch 470a may switch the connected model from the first accurate simulation model 453a, corresponding to the vehicle simulation model, to the first dummy simulation model 453b. Accordingly, a customized simulation tool or package may be provided to an application developer or tester, that reduces cost, computational complexity, processing load, and processing time. For example, a customized simulation tool may be provided to meet the minimum viable requirements for testing a given application.

Although the example above only describes replacing one accurate simulation model with one dummy simulation model, it is understood that embodiments are not limited thereto, and the switches 470a and 470b may selectively switch a plurality of accurate simulation data models and a plurality of dummy simulation data models for testing a given application.

The embodiments of the disclosure have been shown and described, however, the embodiments of the disclosure are not limited to the aforementioned specific embodiments. It may be understood that various modifications, substitutions, and improvements can be made by those having ordinary skill in the art in the technical field to which the disclosure belongs, without departing from the spirit of the disclosure as claimed by the appended claims. It should be understood that such modifications, substitutions, and improvements shall fall within the protection scope of the disclosure, and should not to be construed independently from the technical idea or prospect of the disclosure.

## Claims

1. A server for providing an autonomous driving simulation architecture for testing an application, the server comprising:
a storage storing a plurality of simulation data models;
at least one processor configured to execute instructions to implement:
at least one first interface to integrate the plurality of simulation data models with a first core simulator that runs an autonomous driving simulation for testing the application;
a common interface to selectively connect the first core simulator to a client device providing the application; and
a first switch to selectively disconnect a first simulation data model, among the plurality of simulation data models, from the first core simulator.

2. The server of claim 1, wherein:
the first switch disconnects the first simulation dummy model by switching from the first simulation data model to a first dummy model, for integration with the first core simulator via the at least one first interface; and
the first dummy model is of lower accuracy than the first simulation data model.

3. The server of claim 1 or 2, wherein the at least one processor is further configured to execute the instructions to implement at least one second interface to connect one or more of the plurality of simulation data models with a second core simulator.

4. The server of claim 3, wherein the common interface selectively connects the first core simulator or the second core simulator to the client device.

5. The server of any one of claims 1 to 4, wherein the at least one processor is further configured to execute the instructions to implement a second switch to selectively switch between a second simulation data model, among the plurality of simulation data models, and a second dummy model, for integration with the first core simulator.

6. The server of any one of claims 1 to 5, wherein the plurality of simulation data models comprises a vehicle simulation model for simulating an ego vehicle, and a sensor simulation model for simulating one or more sensors of the ego vehicle.

7. The server of any one of claims 1 to 6, wherein the at least one first interface is configured to convert data between one or more data formats of the plurality of simulation data models and a data format of the first core simulator.

8. A method for providing an autonomous driving simulation architecture for testing an application, the method comprising:
integrating a plurality of simulation data models with a first core simulator that runs an autonomous vehicle simulation for testing the application;
selectively disconnecting a first simulation data model, among the plurality of simulation data models, from the first core simulator; and
selectively connecting the first core simulator to the application.

9. The method of claim 8, wherein the selectively disconnecting the first simulation data model from the first core simulator comprises:
controlling a first switch to disconnect a first simulation dummy model by switching from the first simulation data model to a first dummy model, for integration with the first core simulator,
wherein the first dummy model is of lower accuracy than the first simulation data model.

10. The method of claim 8 or 9, further comprising:
connecting one or more of the plurality of simulation data models with a second core simulator.

11. The method of claim 10, further comprising:
selectively connecting the first core simulator or the second core simulator to a client device via a common interface.

12. The method of any one of claims 8 to 11, further comprising:
controlling a second switch to selectively switch between a second simulation data model, among the plurality of simulation data models, and a second dummy model, for integration with the first core simulator.

13. The method of any one of claims 8 to 12, wherein the plurality of simulation data models comprises a vehicle simulation model for simulating an ego vehicle, and a sensor simulation model for simulating one or more sensors of the ego vehicle.

14. The method of any one of claims 8 to 13, further comprising:
converting data between one or more data formats of the plurality of simulation data models and a data format of the first core simulator.

15. A non-transitory computer-readable storage medium, storing instructions executable by at least one processor to perform a method comprising:
integrating a plurality of simulation data models with a first core simulator that runs an autonomous vehicle simulation for testing an application;
selectively disconnecting a first simulation data model, among the plurality of simulation data models, from the first core simulator; and
selectively connecting the first core simulator to the application.
